# EUROPEAN PATENT APPLICATION

(11) **EP 1 583 411 A2**
(43) Date of publication of application: **05.10.2005**
(21) Application number: 05075537.0
(22) Date of filing: 04.03.2005
(51) Int. Cl.: H05K 13/00, H05K 13/08, H05K 13/04

(54) **Method and system for placing components by means of at least one component placement unit**

(30) Priority: 16.03.2004 EP 04101060
(71) Applicant: Assembléon N.V., 5503 LA Veldhoven (NL)
(72) Inventor: van der Graaf, Sebastiaan Edward, 5621 GG Eindhoven (NL)
(74) Representative: Valkonet, Rutger

(57) **Abstract**

Method of and system for placing components by means of at least one component placement unit (5), wherein the component placement unit (5) is moved over a distance between a component pickup position (19) and a component placement position (15) located on a substrate (11) for the purpose of placing components (14). A total distance to be covered by the component placement unit (5) is calculated for a number of components (14) to be placed, which number is to be determined beforehand. This distance value is subsequently compared with a reference value. If the total distance is greater than the reference value, the substrate (11) to be provided with the components (14) is rotated with respect to the component pickup position (19) about an axis (20) that extends perpendicularly to the substrate (11).

## Description

The invention relates to a method for placing components by means of at least one component placement unit, wherein the component placement unit is moved over a distance between a component pickup position and a component placement position located on a substrate.

The invention further relates to a system comprising at least one component placement unit for placing components, which component placement unit can be moved over a distance between a component pickup position and a component placement position located on a substrate.

With such a method and system, which are known from WO-A-98/24291, components are picked up from at least one component pickup position by means of at least one component placement unit and moved over a distance to a component placement position located on a substrate. A drawback of this known method is the fact that the capacity, i.e. the number of components to be placed per unit time, is relatively low in some cases, because the total distance to be covered by the component placement unit is relatively great in some cases for a specific number of components to be placed on the substrate.

The object of the present invention is to provide a method for increasing the capacity of the component placement unit.

This object is accomplished in the method according to the invention in that a total distance to be covered by the component placement unit is calculated for a number of components to be placed, which number is to be determined beforehand, which total distance is subsequently compared with a reference value, after which, if said total distance is greater than the reference value, the substrate to be provided with components is rotated with respect to the component pickup position about an axis that extends transversely to the substrate, until the calculated distance is smaller than or equal to the reference value.

Since the total distance to be covered between the component pickup position and the component placement position is reduced for a given number of components to be placed, and consequently the time needed for covering said distance is reduced, the number of components to be placed by means of the component placement unit per unit time, i.e. the capacity , is increased.

One embodiment of the method according to the invention is characterized in that the reference value is equal to a total distance to be covered by the component placement unit in the case of a substrate that has been rotated through a predefined angle.

By calculating the total distance to be covered in the case of a rotated substrate and regarding this calculated value as a reference value, it is ensured that, after comparison and possible rotation, the component placement unit will at all times cover the shortest total distance, so that the required time will be shortest and the capacity highest.

Another embodiment of the method according to the invention is characterized in that an average distance to be covered is calculated from the total distance to be covered.

The average distance to be covered can be calculated in a simple manner by dividing the total distance to be covered by the number of components to be placed.

Another embodiment of the method according to the invention is characterized in that the reference value is equal to an average distance to be covered between a centre line of the substrate, which extends transversely to a direction of movement of the component placement unit, and a component pickup position.

This is a simple manner of determining a reference value, which is in particular suitable if movement of the component placement unit between a component pickup position and a component placement position is only possible in a direction that extends transversely to the direction of movement of the substrate.

Another embodiment of the method according to the invention is characterized in that the substrate is rotated in steps of approximately 90 degrees by means of a rotation system.

The substrate can be rotated with respect to the pickup position in a simple manner by means of a rotation system. In the case of rectangular substrates, the substrate is preferably rotated through about 180 degrees by means of the rotation system. Especially in the case of square substrates, a rotation through about 90 degrees may already result in a higher capacity.

Yet another embodiment of the method according to the invention is characterized in that the total distance to be covered by the component placement unit is calculated on the basis of design data of a substrate.

The total distance can be calculated relatively quickly and accurately by means of the design data. The term design data is understood to mean data that provides information about the layout of a substrate and the positions of the components to be placed thereon.

Another object of the present invention is to provide a system having a relatively high capacity.

This object is accomplished with the system according to the invention in that a total distance to be covered by the component placement unit can be calculated for a number of components to be placed, which number is to be determined beforehand, and if said total distance is greater than the reference value, a substrate to be provided with components can be rotated with respect to the component pickup position about an axis that extends transversely with respect to the substrate until the calculated distance is smaller than or equal to the reference value.

By rotating the substrate until the calculated value is smaller than or equal to the reference value, the total distance to be covered for a number of components to be placed is reduced, the time is reduced and consequently the capacity of the component placement unit is increased.

One embodiment of the system according to the invention is characterized in that the system is provided with a processor.

All data regarding a substrate and the positions at which specific components are to be placed can be made available in the processor in a relatively simple manner. By comparing the average distance to be covered by the component placement unit for a number of components to be placed, which average distance is likewise calculated by means of the processor, with a reference value input into the processor, it can readily be determined whether a substrate is to be rotated by means of a rotation system so as to realise a capacity increase.

Another embodiment of the system according to the invention is characterized in that the substrate can be rotated by means of a rotation system that is integrated in the system.

The substrate can be rotated in a simple manner by means of an integrated rotation system. In addition, a rotation system that is integrated in the system takes up little space.

Another embodiment of the system according to the invention is characterized in that the substrate can be rotated by means of a rotation system that can be detachably connected to the system.

A detachably connected rotation system can be used with various systems.

The invention will be explained in more detail with reference to the drawings, in which:
Fig. 1 is a perspective view of a system according to the invention;
Fig. 2 shows two top plan views A, B of a substrate to be provided with components;
Figs. 3a and 3b show top plan views of another substrate;
Fig. 4 is a side elevation of two systems according to the invention, which are coupled by means of a rotation system.

Like parts are indicated by the same numerals in the figures.

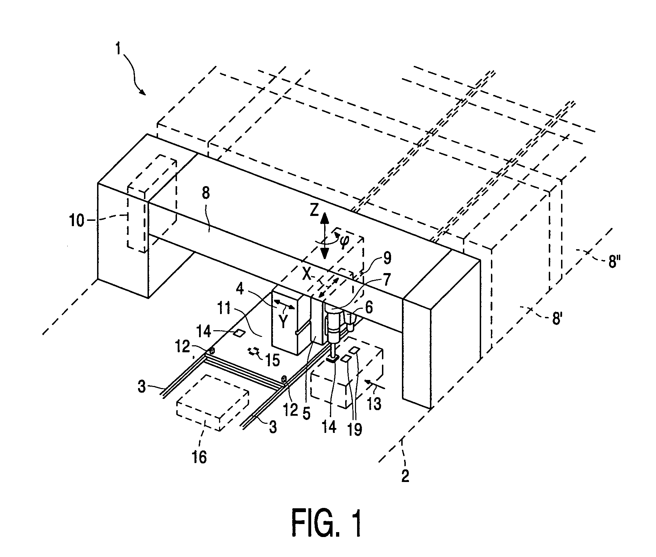

Fig. 1 shows a system 1 according to the invention comprising a frame 2, transport rails 3 supported by the frame 2 and a device 4 which is movable above the transport rails 3, to which a component placement unit 5 is connected. The component placement unit 5 is provided with a camera 6 and a nozzle 7. The device 4 can be moved, by means that are known per se, in the direction indicated by the arrow Y and in the opposite direction via a guide (not shown) that is mounted on a bridge 8. The component placement unit 5 is movable in the direction indicated by the arrow X over a guide 9 that is present on the device 4. The nozzle 7 is furthermore movable in the direction indicated by the arrow Z and in the opposite direction. The system 1 also comprises a processor 10.

A substrate 11 is moved in the direction indicated by the arrow X and in the opposite direction to a position located near the device 4 by means of the transport rails 3. On the substrate 11, a number of reference elements 12 are provided, as are a number of positions 15 at which components are to be placed. A number of component supply devices 13 are arranged beside the transport rails 3, from where the component 14 can be picked up each time by the nozzle 7, which component must subsequently be positioned at a desired component placement position 15 on the substrate 11.

Several bridges 8, 8', 8'' are provided on the frame 2 , over which devices 4 are movable (indicated in dotted lines in Fig. 1).

Disposed between the transport rails 3 is a rotation system 16, by means of which a substrate 11 can be rotated in steps of 180 degrees in the direction indicated by the arrow φ or in the opposite direction. To rotate the substrate 11, the substrate 11 is lifted off the rails 3 temporarily by means of the rotation system 16.

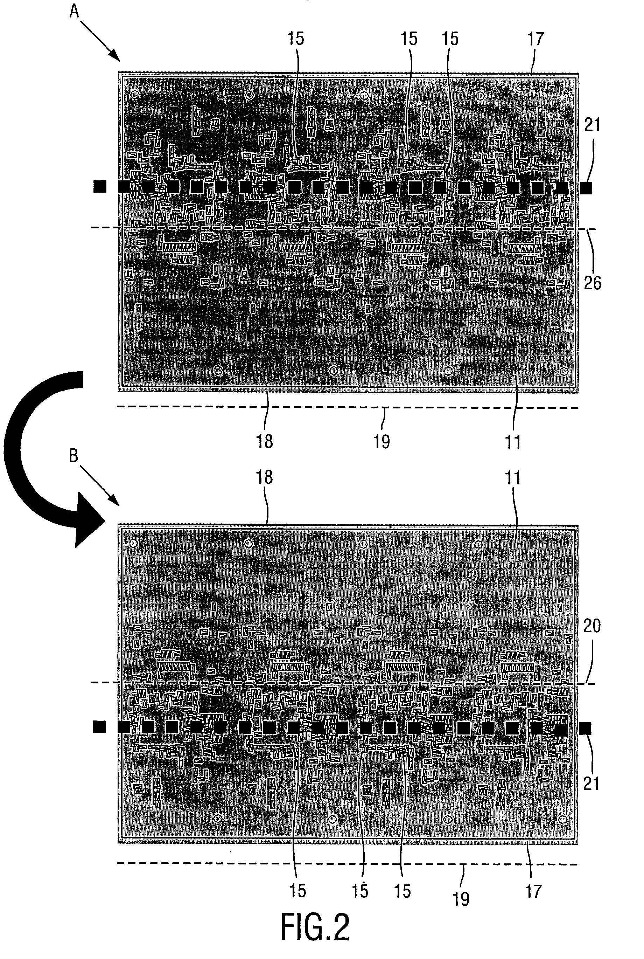

Fig. 2 shows two top plan views A, B of one and the same substrate 11. The substrate 11 comprises sides 17 , 18. The substrate 11 in the lower view B has been rotated through 180 degrees with respect to the substrate 11 in the upper view A. The position of the component supply device 13 relative to the substrate 11 is indicated in a dotted line.

The substrate 11 has a centre line 20, which extends transversely to the direction of movement of the substrate 11. Furthermore, a dotted line 21 is drawn between the side 17 and the centre line 20 in the two views A, B of the substrate 11.

The dotted line 21 represents an average distance to be covered by the component placement unit 4, in a direction transverse to the direction of movement of the substrate 11, for the purpose of picking up a number of components 14 from the component pickup position 13 and placing said components 14 at component placement positions 15.

The value indicated by the dotted line 21 is calculated by a processor 10 from design data. Following that, the processor compares the average distance to be covered by the component placement unit 5 with the distance to be covered to the centre line 20. The distance "centre line 20 - component pickup position 19" is regarded as a reference value here. If the average distance indicated by the dotted line 21 is greater than the reference value represented by the centre line 20, as is the case with the substrate 11 that is shown in view A , the total distance to be covered with the component placement unit 5 for placing a number of components can be reduced in that the rotation system 16 rotates the substrate 11 through 180 degrees. As view B shows, the dotted line 21 is located closer to the component supply device 13 than in view A, so that the distance to be covered by the component placement unit 5 for placing a number of components is smaller, so that the component placement unit 11 can place more components 14 per unit time on the substrate 11, given the same speed of movement, and the capacity of the system 1 is relatively high.

The distance "centre line substrate 20 - component pickup position 19" can be used in particular if the device 4, as well as the component placement unit 5, are moved in one direction only, e.g. only in the y-direction indicated in Fig. 1, upon movement between the component pickup position 19 and the component placement position 15.

It is also possible to utilize the rotation of the substrate 11 for a system 1 in which the component placement unit 5 is movable in the x-direction as well as in the y-direction. By shortening the total distance both in the x-direction and in the y-direction, the time needed for placing the components is reduced as well, and consequently the capacity of the system 1 is increased.

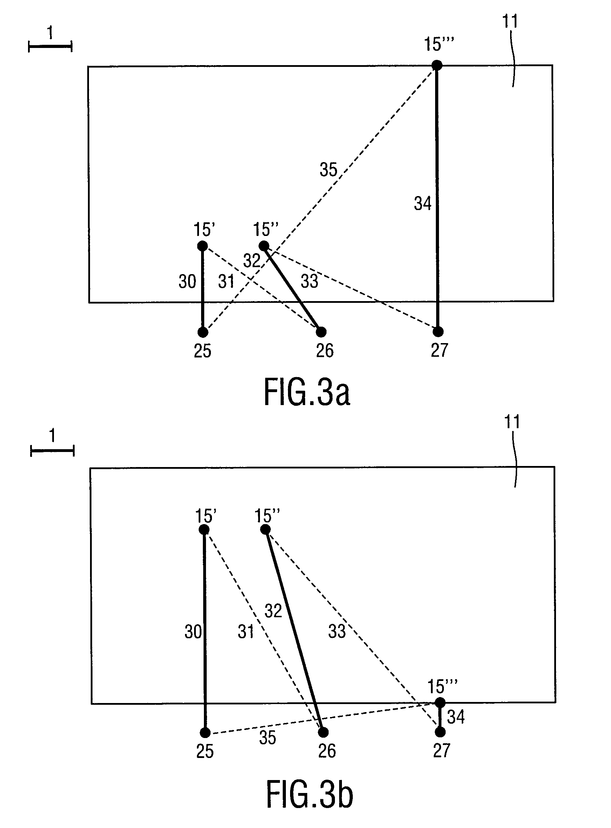

An example of the determination of the reference value for the component placement unit 5 that is movable both in the x-direction and in the y-direction is shown in Figs. 3a and 3b.

Fig. 3a is a top plan view of a substrate 11. Fig. 3b is a top plan view of one and the same substrate 11, in which the substrate 11 has been rotated through 180 degrees, however. Numerals 25, 26, 27 indicate different component pickup positions, whilst numerals 15', 15'', and 15''' indicate the component placement positions. The total distance to be covered by the component placement unit 5 for picking up and placing components in the case of a non-rotated substrate 11 and in the case of a rotated substrate 11 is the sum of the distances 30, 31, 32, 33, 34 and 35. For easy reference, the distances between the component pickup positions 25, 26, 27 and the component placement positions 15', 15", 15''' are illustrated in full lines, and the distances between the component placement positions 15', 15'', 15''' and the component pickup positions 25, 26, 27 are illustrated in dotted lines.

The reference value is calculated by the processor 10 in that the total distance to be covered in the case of a rotated substrate 11 (Fig. 3b) is calculated. Following that, the calculated total distance to be covered in the case of a non-rotated substrate (Fig. 3a) is compared with the reference value. If the total distance to be covered in the case of the non-rotated substrate is greater than the reference value, the substrate will have to be rotated through 180 degrees. The shortest distance can at all times be calculated by means of a reference value that has been determined in this manner.

Calculated for the unit that is shown in Fig. 3a, the total distance to be covered by the component placement unit 5 is 39.36 in the case of a non-rotated substrate (Fig. 3a) and 41.62 in the case of a rotated substrate (Fig. 3b).

The reference value now equals 41.62, which value is compared with the value 39.36 by the processor. Since the total distance is shorter in the case of the non-rotated substrate 11, the substrate 11 need not be rotated in this case.

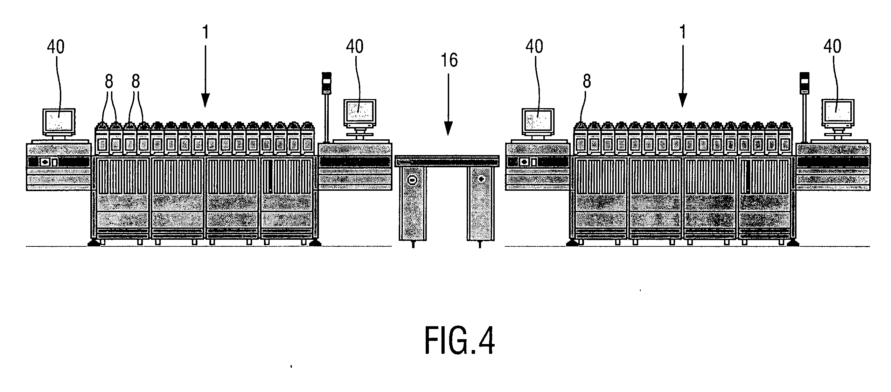

Fig. 4 is a side elevation of two systems 1, 1', which are coupled by means of a movable rotation system 16. Such a rotation system is positioned between two systems 1, 1', for example, if in system 1 the highest number of components per unit time can be placed on a non-rotated substrate in system 1, whereas in system 1' the highest number of components per unit time can be placed on a rotated substrate.

In system 1, the component placement units 5 mainly place components on the side of the centre line that is most proximate to the component pickup positions 19 that are located on one side of the substrate. After being rotated through 180 degrees by means of the rotation system 16, the rotated substrate 11 is provided with components mainly on the other side of the centre line in system 1'. The total distance covered by the component placement units of system 1 and system 1' is reduced by means of the rotation system 16.

The rotation system 16 may be disposed in front of a number of bridges 8, 8', 8'' and the associated component placement units, as is shown in Fig. 1. As in Fig. 4, the processor then calculates the total distance to be covered by all component placement units and compares this distance value with a reference value. It is also possible to dispose a separate rotation system at each bridge and the component placement unit connected thereto, so that the total distance to be covered can be reduced for each component placement unit 5 individually by means of the rotation system.

If a system comprises two component supply devices positioned opposite each other, it is moreover possible to exchange the component supply devices rather than rotate the substrate that is positioned between the component supply devices, which can be effected by detachably connecting said component supply devices to the system.

In principle, the angle through which a rectangular substrate is rotated by means of a rotation system can be selected at random. If steps of a magnitude other than 180 degrees are used, however, the transport rails must be provided with supplementary means in order to ensure a correct guidance of a substrate that has been rotated through a randomly selected angle. A square substrate, on the other hand, can be rotated in steps of 90 degrees without adaptations of the transport rails being required.

## Claims

1. A method for placing components by means of at least one component placement unit (5), wherein the component placement unit is moved over a distance between a component pickup position (25-27) and a component placement position (15) located on a substrate (11), **characterized in that** a total distance to be covered by the component placement unit (5) is calculated for a number of components to be placed, which number is to be determined beforehand, which total distance is subsequently compared to a reference value, after which, if said total distance is greater than the reference value, the substrate (11) to be provided with components is rotated with respect to the component pickup position (19; 25-27) about an axis that extends transversely to the substrate (11), until the calculated distance is smaller than or equal to the reference value.

2. A method according to claim 1, **characterized in that** the reference value is equal to a total distance to be covered by the component placement unit (5) in the case of a substrate (11) that has been rotated through a predefined angle.

3. A method according to any one of the claims 1 or 2, **characterized in that** an average distance to be covered is calculated from the total distance to be covered.

4. A method according to claim 3, **characterized in that** the reference value is equal to an average distance to be covered between a centre line of the substrate (11), which extends transversely to a direction of movement of the component placement unit (5), and a component pickup position (19; 25-27).

5. A method according to any one of the preceding claims 1-4, **characterized in that** the substrate (11) is rotated in steps of approximately 90 degrees by means of a rotation system.

6. A method according to any one of the preceding claims, **characterized in that** the total distance to be covered by the component placement unit (5) is calculated on the basis of design data of a substrate (11).

7. A system comprising at least one component placement unit (5) for placing components, which component placement unit (5) can be moved over a distance between a component pickup position (13) and a component placement position (15) located on a substrate (11), **characterized in that** a total distance to be covered by the component placement unit (5) can be calculated for a number of components to be placed, which number is to be determined beforehand, and if said total distance is greater than the reference value, a substrate (11) to be provided with components can be rotated with respect to the component pickup position (13) about an axis that extends transversely with respect to the substrate (11) until the calculated distance is smaller than or equal to the reference value.

8. A system according to claim 6, **characterized in that** the system comprises a processor.

9. A system according to claim 6 or 7, **characterized in that** the substrate (11) can be rotated by means of a rotation system that is integrated in the system.

10. A system according to claim 6 or 7, **characterized in that** the substrate (11) can be rotated by means of a rotation system that can be detachably connected to the system.
